# EUROPEAN PATENT APPLICATION

(11) **EP 4 333 422 A1**
(43) Date of publication of application: **06.03.2024**
(21) Application number: 22795215.7
(22) Date of filing: 08.02.2022
(51) Int. Cl.: H04N 5/369, H01L 27/146, H01L 27/30

(54) **SOLID-STATE IMAGING DEVICE, ELECTRONIC EQUIPMENT, AND MOVING BODY**

(30) Priority: 30.04.2021 JP 2021077975
(71) Applicant: Sony Semiconductor Solutions Corporation, Atsugi-shi, Kanagawa 243-0014 (JP)
(72) Inventor: WATANABE, Taiichiro, Atsugi-shi, Kanagawa 243-0014 (JP); KOGA, Fumihiko, Atsugi-shi, Kanagawa 243-0014 (JP)
(74) Representative: Müller Hoffmann & Partner
(86) International application number: PCT/JP2022/004901
(87) International publication number: WO 2022/230292

(57) **Abstract**

A solid-state imaging device according to an embodiment of the present disclosure includes a semiconductor layer, a first capacitor section, and a second capacitor section. The semiconductor layer is stacked on a first Si substrate, and includes a photoelectric conversion region and a floating diffusion region. The photoelectric conversion region has a predetermined wavelength selectivity. The floating diffusion region converts electric charge transferred from the photoelectric conversion region into an electric signal and outputs the electric signal. The first capacitor section is formed in the first Si substrate, and holds a reset voltage of the floating diffusion region at the time when a voltage of the floating diffusion region is reset. The second capacitor section is formed in the first Si substrate, and holds a signal voltage generated by the electric signal.

## Description

### Technical Field

The present disclosure relates to a solid-state imaging device, an electronic apparatus, and a mobile body.

### Background Art

In the past, various solid-state imaging devices have been proposed (see, for example, PTLs 1 and 2).

### Citation List

### Patent Literature

PTL 1: Japanese Unexamined Patent Application Publication No. 2017-157816 PTL 2: Japanese Unexamined Patent Application Publication No. 2018-107724

### Summary of the Invention

Incidentally, in the above-described solid-state imaging device, from the viewpoint of improving image quality, an improvement in an SN ratio (Signal-noise ratio) and application of a global shutter method are desired. Thus, it is desirable to provide a solid-state imaging device that is able to adopt a global shutter method while achieving a high SN ratio, and an electronic apparatus and a mobile body including the solid-state imaging device.

A solid-state imaging device according to an embodiment of the present disclosure includes: a semiconductor layer, a first capacitor section, and a second capacitor section. The semiconductor layer is stacked on a first Si substrate, and includes a photoelectric conversion region and a floating diffusion region. The photoelectric conversion region has a predetermined wavelength selectivity. The floating diffusion region converts electric charge transferred from the photoelectric conversion region into an electric signal and outputs the electric signal. The first capacitor section is formed in the first Si substrate, and holds a reset voltage of the floating diffusion region at the time when a voltage of the floating diffusion region is reset. The second capacitor section is formed in the first Si substrate, and holds a signal voltage generated by the electric signal.

An electronic apparatus according to an embodiment of the present disclosure includes the solid-state imaging device described above.

A mobile body according to an embodiment of the present disclosure includes the solid-state imaging device described above.

In the solid-state imaging device, the electronic apparatus and the mobile body according to an embodiment of the present disclosure, two capacitor sections (a first capacitor section and a second capacitor section) are formed in an Si substrate. Thus, for example, by determining a difference between a reset voltage that is held in the first capacitor section and a signal voltage that is held in the second capacitor section, it is possible to remove a noise included in the signal voltage. As a result, it is possible to suppress generation of kTC noise. Further, in the present disclosure, the semiconductor layer is provided with the floating diffusion region separately from the photoelectric conversion region, and electric charge generated in the photoelectric conversion region is transferred to the floating diffusion region. Here, it is possible to remove noise by the two capacitor sections provided at the subsequent stage of the floating diffusion region, thus making it possible to reduce a capacitance of the floating diffusion region. This increases conversion efficiency and improves SN.

### Brief Description of the Drawings

[FIG. 1] FIG. 1 is a schematic view of an example of a configuration of a solid-state imaging device according to an embodiment of the present disclosure.
[FIG. 2] FIG. 2 is a diagram illustrating an example of a circuit configuration of a sensor pixel.
[FIG. 3] FIG. 3 is a diagram illustrating an example of a cross-sectional configuration of the sensor pixel.
[FIG. 4] FIG. 4 is a diagram illustrating a modification example of a circuit configuration of an S/H section.
[FIG. 5] FIG. 5 is a diagram illustrating a modification example of a circuit configuration of the sensor pixel.
[FIG. 6] FIG. 6 is a diagram illustrating a modification example of a circuit configuration of an amplification section.
[FIG. 7] FIG. 7 is a diagram illustrating a modification example of the cross-sectional configuration of the sensor pixel.
[FIG. 8] FIG. 8 is a diagram illustrating a modification example of the cross-sectional configuration of the sensor pixel.
[FIG. 9] FIG. 9 is a diagram illustrating a modification example of the cross-sectional configuration of the sensor pixel.
[FIG. 10] FIG. 10 is a diagram illustrating a modification example of the cross-sectional configuration of the sensor pixel.
[FIG. 11] FIG. 11 is a diagram illustrating an example of a schematic configuration of an imaging system including the solid-state imaging device according to any of the embodiment described above and the modification examples thereof.
[FIG. 12] FIG. 12 is a block diagram depicting an example of schematic configuration of a vehicle control system.
[FIG. 13] FIG. 13 is a diagram of assistance in explaining an example of installation positions of an outside-vehicle information detecting section and an imaging section.
[FIG. 14] FIG. 14 is a view depicting an example of a schematic configuration of an endoscopic surgery system.
[FIG. 15] FIG. 15 is a block diagram depicting an example of a functional configuration of a camera head and a camera control unit (CCU).

### Modes for Carrying Out the Invention

The following describes a preferred embodiment of the present disclosure in detail with reference to the accompanying drawings. It is to be noted that, in the present description and drawings, components having substantially the same functional configuration are denoted by the same reference numerals, and redundant descriptions thereof are thus omitted.

In addition, in the present specification and drawings, a plurality of components having substantially the same or similar functional configuration is distinguished by adding different numerals to the ends of the same reference numerals in some cases. However, in a case where there is no need to particularly distinguish a plurality of components having substantially the same or similar functional configuration from each other, the same reference numerals alone are attached. In addition, similar components of different embodiments are distinguished by attaching different alphabets to the same reference numerals in some cases. However, in a case where there is no need to particularly distinguish similar components from each other, the same reference numerals alone are attached.

In addition, the drawings to be referred to in the following description are intended to describe an embodiment of the present disclosure and facilitate an understanding thereof; shapes, dimensions, ratios, and the like illustrated in the drawings may differ from actual ones, in some cases, for better understanding. Further, the design of a solid-state imaging element illustrated in the drawings can be modified as appropriate by taking into consideration the following description and known techniques. In addition, in the description using the cross-sectional view of the solid-state imaging element, the up/down direction of the stacked structure of the solid-state imaging element corresponds to a relative direction in a case where an incidence surface of the solid-state imaging element that light enters is defined as a top surface. The up/down direction may differ, in some cases, from an up/down direction that is compliant with the actual gravitational acceleration.

In addition, in the following description, expressions regarding a size and a shape do not only mean the same values as a numerical value defined mathematically or a shape defined geometrically, but also include, for example, a shape in a case of having an industrially acceptable difference in a step of manufacturing the solid-state imaging element or even a shape similar thereto.

Further, in the following description of circuit configurations, unless otherwise specified, "coupling" means electrical coupling between a plurality of elements. In addition, "coupling" in the following description includes not only a case of coupling a plurality of elements directly and electrically, but also a case of coupling the plurality of elements indirectly and electrically via another element.

It is to be noted that description is given in the following order.
1. Embodiment (solid-state imaging device)
2. Modification Examples (solid-state imaging device)
3. Application Example (imaging system)
4. Practical Application Examples

### Example of Practical Application to Mobile Body

### Example of Practical Application to Endoscopic Surgery System

### <1. Embodiment>

### [Configuration]

A solid-state imaging device 1 according to an embodiment of the present disclosure is described. The solid-state imaging device 1 is, for example, an image sensor of a global shutter method including a CMOS (Complementary Metal Oxide Semiconductor) image sensor, or the like. The solid-state imaging device 1 receives light from a subject and performs photoelectric conversion to generate an image signal, thereby capturing an image. The solid-state imaging device 1 outputs a pixel signal corresponding to incident light.

The global shutter method is a method of performing global exposure in which exposure is basically started simultaneously for all pixels, and exposure is finished simultaneously for all the pixels. Here, all the pixels refer to all of pixels in a portion that appears in an image, and exclude dummy pixels, or the like. In addition, the global shutter method also includes a method in which a region where global exposure is performed is moved while performing global exposure in a unit of a plurality of rows (e.g., several tens of rows) instead of all the pixels simultaneously when a time difference or an image distortion is small enough not to be an issue. In addition, the global shutter method also includes a method in which global exposure is performed on pixels in a predetermined region, instead of all of the pixels in the portion that appears in the image. It is to be noted that the present disclosure is not limited to the application to the CMOS image sensor.

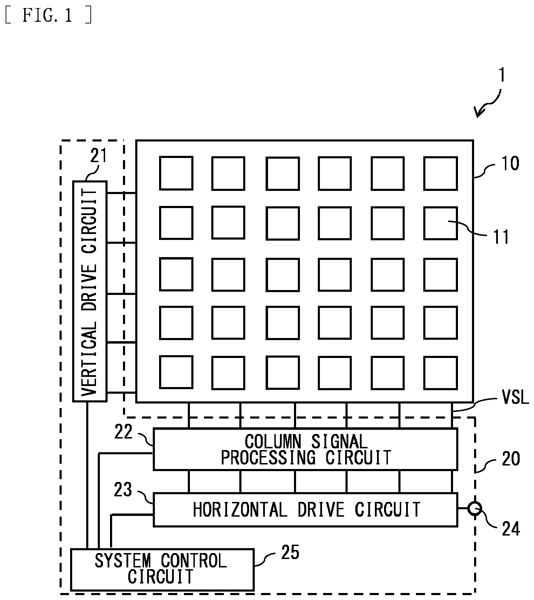

FIG. 1 illustrates an example of a schematic configuration of the solid-state imaging device 1. The solid-state imaging device 1 includes a pixel array section 10 in which a plurality of sensor pixels 11 that perform photoelectric conversion are arranged in matrix. The sensor pixel 11 corresponds to a specific example of a "pixel" of the present disclosure. The solid-state imaging device 1 further includes a peripheral circuit 20 disposed in a peripheral region of the pixel array section 10. The peripheral circuit 20 includes a vertical drive circuit 21, a column signal processing circuit 22, a horizontal drive circuit 23, an output circuit 24, and a system control circuit 25.

The pixel array section 10 is provided with, for example, the plurality of sensor pixels 11 that are two-dimensionally arranged in matrix. The pixel array section 10 is provided with, for example, a plurality of pixel rows that includes the plurality of sensor pixels 11 arranged in a horizontal direction (in a traverse direction of the sheet) and a plurality of pixel columns that includes the plurality of sensor pixels 11 arranged in a vertical direction (in a longitudinal direction of the sheet). In the pixel array section 10, for example, a plurality of pixel drive lines are provided for respective pixel rows, and one vertical signal line VSL is provided for each pixel column. The pixel drive line transmits a control signal for reading a signal from each of the sensor pixels 11. Ends of the plurality of pixel drive lines are respectively coupled to a plurality of output terminals corresponding to the respective pixel rows of the vertical drive circuit 21.

The vertical drive circuit 21 includes a shift register, an address decoder, or the like, and is a pixel drive section that drives each of the sensor pixels 11 in, for example, a unit of pixel rows. The pixel signal outputted from each of the sensor pixels 11 of the pixel row selectively scanned by the vertical drive circuit 21 is supplied to the column signal processing circuit 22 through each of the vertical signal lines VSL.

The column signal processing circuit 22 is disposed for each column of the pixel array section 10, and performs signal processing such as noise removal for each pixel column on the pixel signal outputted from the sensor pixels 11 for a predetermined unit of pixel rows. The column signal processing circuit 22 performs a correlated double sampling (Correlated Double Sampling: CDS) process, for example, to remove pixel-specific fixed pattern noise. The column signal processing circuit 22 includes, for example, a single-slope A/D converter. The single-slope A/D converter includes, for example, a comparator and a counter circuit, and performs AD (Analog-Digital) conversion on the pixel signal.

The horizontal drive circuit 23 includes, for example, a shift register. The horizontal drive circuit 23 sequentially outputs horizontal scanning pulses to sequentially select each of the column signal processing circuits 22 described above and outputs the pixel signal from each of the column signal processing circuits 22 to the horizontal signal line.

The output circuit 24 performs signal processing on the pixel signals sequentially supplied from each of the column signal processing circuits 22 through the horizontal signal lines, and outputs the resultant pixel signals. The output circuit 24 may function, for example, as a functional section that performs buffering (buffering), and may perform processes such as black level adjustment, column variation correction, and various types of digital signal processing. The buffering refers to temporarily storing the pixel signals to compensate for differences in processing speed and transfer speed in exchanging the pixel signals.

The system control circuit 25 receives a clock provided from the outside, data for issuing an instruction about an operation mode, or the like. In addition, the system control circuit 25 outputs data such as internal information on the sensor pixel 11. The system control circuit 25 further includes a timing generator that generates various timing signals. The system control circuit 25 controls driving of peripheral circuits such as the vertical drive circuit 21, the column signal processing circuit 22, and the horizontal drive circuit 23 on the basis of various timing signals generated by the timing generator.

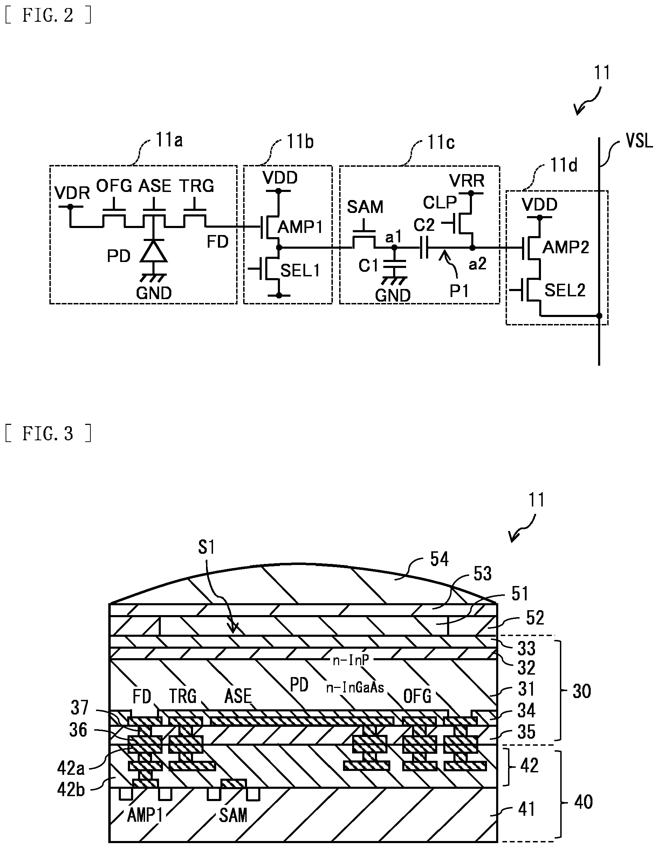

FIG. 2 illustrates an example of a circuit configuration of the sensor pixel 11. As illustrated in FIG. 2, the sensor pixel 11 includes, for example, a photoelectric conversion section 11a, an amplification section 11b, an S/H (Sample and Hold) section 11c, and a readout section 11d.

The photoelectric conversion section 11a includes, for example, a discharge transistor OFG, an electric charge accumulation transistor ASE, a transfer transistor TRG, a photoelectric conversion element PD, and a floating diffusion FD. The discharge transistor OFG, the electric charge accumulation transistor ASE, and the transfer transistor TRG each include, for example, an N-type MOS transistor. A pixel drive line is coupled to each of gates of the discharge transistor OFG, the electric charge accumulation transistor ASE, and the transfer transistor TRG.

The discharge transistor OFG has a drain coupled to a power supply line VDR and a source coupled to the photoelectric conversion element PD via the electric charge accumulation transistor ASE. The discharge transistor OFG initializes (resets) the photoelectric conversion element PD in accordance with a reset signal applied to a gate electrode. For example, when the discharge transistor OFG, the electric charge accumulation transistor ASE, and the transfer transistor TRG are turned on, a potential of the photoelectric conversion element PD is reset to a level of a power supply voltage VDD. In other words, the photoelectric conversion element PD is initialized.

The electric charge accumulation transistor ASE controls a potential of the photoelectric conversion element PD in accordance with a drive signal applied to the gate electrode. For example, when the electric charge accumulation transistor ASE is turned on, the potential of the photoelectric conversion element PD becomes deeper, and when the electric charge accumulation transistor ASE is turned off, the potential of the photoelectric conversion element PD becomes shallower. The transfer transistor TRG is coupled between the electric charge accumulation transistor ASE and the floating diffusion FD, and transfers the electric charge held in the photoelectric conversion element PD to the floating diffusion FD in accordance with the drive signal applied to the gate electrode. For example, when the electric charge accumulation transistor ASE and the transfer transistor TRG are turned on, the electric charge accumulated in the photoelectric conversion element PD is transferred to the floating diffusion FD via the electric charge accumulation transistor ASE and the transfer transistor TRG.

The floating diffusion FD is a floating diffusion region that converts the electric charge that has been transferred from the photoelectric conversion element PD via the transfer transistor TRG into an electric signal (e.g., a voltage signal) and outputs the converted electric signal. The amplification section 11b in a subsequent stage is coupled to the floating diffusion FD.

The amplification section 11b includes, for example, an amplification transistor AMP1 and a selection transistor SEL1. The amplification transistor AMP1 and the selection transistor SEL1 each include, for example, an N-type MOS transistor. The floating diffusion FD is coupled to a gate of the amplification transistor AMP1. The amplification transistor AMP1 has a drain coupled to a power supply line VDD and a source coupled to a drain of the selection transistor SEL1. A row selection line is coupled to a gate of the selection transistor SEL1. The selection transistor SEL1 has the drain coupled to the source of the amplification transistor AMP1 and a source coupled to a constant voltage line. The amplification section 11b is, for example, a source follower circuit that reads a voltage of the floating diffusion FD.

The S/H section 11c includes a capacitor C1 to hold a P-phase voltage as a reference of a signal, and a capacitor C2 to hold a D-phase voltage as a photoelectrically converted output. The capacitors C1 and C2 include, for example, MIM (metal-insulator-meta) type, MOS capacitor, or trench capacitor. The MOS capacitor refers to a capacitor using a gate oxide film capacitance between a gate and an Si substrate. The trench capacitor is an element in which a gate is embedded in the Si substrate and an area of the oxide film is increased to thereby enable an increased capacitance. The S/H section 11c further includes a sampling transistor SAM and a clip transistor CLP. The sampling transistor SAM and the clip transistor CLP each include an N-type MOS transistor, for example.

The row selection line is coupled to a gate of the sampling transistor SAM. The sampling transistor SAM has a drain coupled to a coupling point between the amplification transistor AMP1 and the selection transistor SEL1 and a source coupled to a coupling point a1 between the capacitor C1 and the capacitor C2. The sampling transistor SAM is inserted in series into a signal path P1 from the floating diffusion FD to the readout section 11d. One ends of the capacitor C1 and the capacitor C2 are coupled to the source of the sampling transistor SAM. Another end of the capacitor C1 is coupled to a ground line GND. Another end of the capacitor C2 is coupled to the readout section 11d. The capacitor C1 is branched from and coupled to the signal path P1. The capacitor C2 is inserted in series into the signal path P1. The row selection line is coupled to a gate of the clip transistor CLP. The clip transistor CLP has a drain coupled to a power supply line VRR and a source coupled to a terminal of the capacitor C2 on a side of the readout section 11d.

The S/H section 11c holds, in the capacitor C1, the voltage (a reset voltage) of the floating diffusion FD at the time when the voltage of the floating diffusion FD is reset. The S/H section 11c further holds, in the capacitor C2, a signal voltage that is generated by the electric signal (e.g., voltage signal) outputted from the floating diffusion FD.

The readout section 11d reads the reset voltage from the capacitor C1 and the signal voltage from the capacitor C2. The readout section 11d amplifies a signal outputted from the S/H section 11c, and outputs the signal to the vertical signal line VSL. The readout section 11d includes, for example, an amplification transistor AMP2 and a selection transistor SEL2. The capacitor C2 is coupled to a gate of the amplification transistor AMP2 via the signal path P 1. The amplification transistor AMP2 has a drain coupled to the power supply line VDD and a source coupled to a drain of the selection transistor SEL2. The row selection line is coupled to a gate of the selection transistor SEL2. The selection transistor SEL2 has the drain coupled to the source of the amplification transistor AMP2 and the drain coupled to the vertical signal line VSL. The readout section 11d is, for example, a source follower circuit that reads a voltage of a terminal of the capacitor C2 on the side of the readout section 11d.

FIG. 3 illustrates an example of a cross-sectional configuration of the sensor pixel 11. The sensor pixel 11 includes, for example, two substrates (a light-receiving substrate 30 and a signal processing substrate 40) attached to each other. The two substrates (the light-receiving substrate 30 and the signal processing substrate 40) are attached to each other, for example, by a pad electrode 36 on a side of the light-receiving substrate 30 and a pad electrode 42a on a side of the signal processing substrate 40 being bonded to each other.

The sensor pixel 11 further includes, for example, a color filter layer 51, a black matrix 52, a protective layer 53, and a lens 54 on a side of a light incident surface S1 of the light-receiving substrate 30. The color filter layer 51 is disposed at a position opposed to a photodiode PD, and is in contact with the light incident surface S1 of the light-receiving substrate 30, for example. The color filter layer 51 is disposed for each sensor pixel 11, for example. The black matrix 52 is disposed in the same layer as the color filter layer 51, and is in contact with the light incident surface S1 of the light-receiving substrate 30, for example. The black matrix 52 is disposed at a boundary part of the sensor pixel 11, and covers a side surface of the color filter layer 51. The protective layer 53 is disposed in contact with surfaces of the color filter layer 51 and the black matrix 52, and protects the color filter layer 51 and the black matrix 52. The protective layer 53 includes, for example, a well-known insulating material (e.g., SiO₂ or SiN). The lens 54 is disposed at a position opposed to the photodiode PD, and is in contact with the protective layer 53, for example. The lens 54 is disposed for each sensor pixel 11, for example.

The light-receiving substrate 30 is stacked on the signal processing substrate 40. The light-receiving substrate 30 includes, for example, a semiconductor layer 31. The semiconductor layer 31 includes the photodiode PD which is a photoelectric conversion region, and the floating diffusion FD. The discharge transistor OFG, the electric charge accumulation transistor ASE, and the transfer transistor TRG are formed on a surface of the semiconductor layer 31 on the side of the signal processing substrate 40. An insulating layer 34 is formed in contact with the surface of the semiconductor layer 31 on the side of the signal processing substrate 40. A portion of the insulating layer 34 constitutes gate insulating films of the discharge transistor OFG, the electric charge accumulation transistor ASE, and the transfer transistor TRG.

The insulating layer 34 is provided with a plurality of openings. The floating diffusion FD is electrically coupled to the gate of the amplification transistor AMP1 via wiring lines in insulating layers 35 and 42b described later. In addition, a drain of the discharge transistor OFG is electrically coupled to the power supply line VDR via the wiring lines in the insulating layers 35 and 42b described later. In addition, the gates of the electric charge accumulation transistor ASE, the transfer transistor TRG, and the discharge transistor OFG are respectively coupled to the plurality of pixel drive lines via the wiring lines in the insulating layers 35 and 42b described later. The plurality of pixel drive lines is provided in the insulating layer 42b, for example.

The insulating layer 35 is formed in contact with a surface of the insulating layer 34 on the side of the signal processing substrate 40. The insulating layer 35 is a layer that protects the transfer transistor TRG or the like disposed on the semiconductor layer 31. A plurality of pad electrodes 36 is disposed on a surface of the insulating layer 35 on the side of the signal processing substrate 40. A coupling section 37 that electrically couples the floating diffusion FD and the pad electrode 36 to each other is formed in the insulating layer 35. The coupling section 37 that electrically couples to each other the drain of the discharge transistor OFG and a pad electrode 36 different from the pad electrode 36 electrically coupled to the floating diffusion FD is further formed in the insulating layer 35. The coupling section 37 is, for example, a vertical wiring line penetrating the insulating layer 35 in a thickness direction.

A dark current suppressing layer 32 and a transparent electrode layer 33 are stacked in this order from a side of the light incident surface S1 on the surface of the semiconductor layer 31 on the side of the light incident surface S1. The dark current suppressing layer 32 suppresses a dark current generated in the semiconductor layer 31. The transparent electrode layer 33 is an electrode of the photodiode PD on the side of the light incident surface S1. The transparent electrode-layer 33 is provided at a position facing the light incident surface S1.

The semiconductor layer 31 is a layer including a material that is different from that of the Si substrate (described later) included in the signal processing substrate 40. The semiconductor layer 31 (photodiode PD) includes, for example, an InGaAs layer, an organic photoelectric conversion layer, a Ge layer, an SiGe layer, an amorphous silicon layer, or a quantum dot layer. The insulating layer 345 includes, for example, a well-known insulating material (e.g., SiO₂ or SiN). In a case where the semiconductor layer 31 is the InGaAs layer, the dark current suppressing layer 32 is, for example, an InP layer. The transparent electrode layer 33 includes, for example, a transparent electrically-conductive material such as ITO (Indium Tin Oxide) or IZO (Indium Zinc Oxide).

The signal processing substrate 40 includes, for example, a semiconductor substrate 41. The semiconductor substrate 41 is, for example, an Si substrate. For example, the amplification section 11b, the S/H section 11c (capacitors C1 and C2), and the readout section 11d are formed in the semiconductor substrate 41. A wiring layer 42 is stacked on a surface of the semiconductor substrate 41 on the side of the light-receiving substrate 30. The wiring layer 42 includes, for example, a plurality of pad electrodes 42a, a plurality of wiring lines electrically coupling the plurality of pad electrodes 42a and the capacitors C1, C2, and the like to each other, and the insulating layer 42b that insulates and isolates the plurality of pad electrodes 42a and the capacitors C1, C2, and the like from each other. The plurality of pad electrodes 35a and the plurality of pad electrodes 42a are attached to each other by being bonded to each other.

### [Operation]

Next, an operation of the solid-state imaging device 1 is described. First, the solid-state imaging device 1 turns on and off the discharge transistor OFG, the electric charge accumulation transistor ASE, and the transfer transistor TRG. This starts accumulation, into the semiconductor layer 31, of the signal charge generated by the photoelectric conversion in the photodiode PD. Next, the solid-state imaging device 1 turns on the selection transistor SEL1, then turns on the sampling transistor SAM, and turns on and off the clip transistor CLP. This resets each of a voltage of the floating diffusion FD, a voltage V1 at the coupling point a1 between the capacitor C1 and the capacitor C2, and a voltage V2 at a coupling point a2 between the capacitor C2 and the clip transistor CLP to a predetermined value. A potential difference corresponding to the voltage V1 at the coupling point a1 at this time is applied to the capacitor C1.

Next, the solid-state imaging device 1 turns on and off the transfer transistor TRG. This allows the signal charge accumulated in the semiconductor layer 31 (photodiode PD) to be transferred from the semiconductor layer 31 (photodiode PD) to the floating diffusion FD. Thereafter, the voltage of the floating diffusion FD is amplified by the amplification transistor AMP1, and is applied to the coupling point a1 via the sampling transistor SAM. A variation in the voltage V1 at the coupling point a1 is propagated to the coupling point a2 by capacitive coupling, thereby varying the voltage V2 at the coupling point a2. Thereafter, the solid-state imaging device 1 turns off the sampling transistor SAM and the selection transistor SEL1.

Next, the solid-state imaging device 1 performs rolling readout for each pixel row. Specifically, the solid-state imaging device 1 first turns on the selection transistor SEL2 for each pixel row. Then, the voltage V2 (signal voltage) at the coupling point a2 is inputted to the column signal processing circuit 22 via the vertical signal line VSL for each pixel row. The column signal processing circuit 22 performs A/D conversion on the inputted signal voltage. The solid-state imaging device 1 turns on the selection transistor SEL2 for each pixel row, and then turns on and off the clip transistor CLP. This allows the voltage V2 at the coupling point a2 to be a voltage value corresponding to the potential difference accumulated in the capacitor C1. The voltage V2 (reset voltage) at the coupling point a2 at this time is inputted to the column signal processing circuit 22 via the vertical signal line VSL for each pixel row. The column signal processing circuit 22 performs A/D conversion on the inputted reset voltage. The column signal processing circuit 22 outputs, as a pixel signal, a voltage corresponding to a difference between the signal voltage and the reset voltage to the output circuit 24. In this way, it is possible to perform driving of the global shutter method.

### [Effects]

Next, effects of the solid-state imaging device 1 are described.

In recent years, in a CCD image sensor or the CMOS image sensor, the amount of light that enters a unit pixel decreases as a pixel size is decreased, thus decreasing a sensitivity and decreasing an S/N ratio. In particular, reducing kTC noise generated during a reset operation is an issue in terms of improving image quality. In addition, in terms of improving image quality, it is also important to adopt the global shutter method. Therefore, it is required to achieve a solid-state imaging device that makes it possible to adopt the global shutter method while reducing the kTC noise.

Meanwhile, in the present embodiment, the two capacitors C1 and C2 are formed in the semiconductor substrate 41 (Si substrate). Accordingly, for example, by determining a difference between the reset voltage held in the capacitor C1 and the signal voltage held in the capacitor C2, it is possible to remove a noise included in the signal voltage. As a result, it is possible to suppress the generation of the kTC noise. Further, in the present embodiment, the semiconductor layer 31 is provided with the floating diffusion FD separately from the photodiode PD, and the electric charge generated in the floating diffusion FD is transferred to the photodiode PD. Here, the two capacitors C1 and C2 provided in a subsequent stage of the floating diffusion FD enable noise removal, thus making it possible to reduce the capacitance of the floating diffusion FD. This increases the conversion efficiency and improves the SN.

Further, in the present embodiment, the capacitor C2 is inserted in series into the signal path P1 from the floating diffusion FD to the readout section 11d, and the capacitor C1 is branched from and coupled to the signal path P1. This enables the capacitor C1 to hold the reset voltage and the capacitor C2 to hold the signal voltage. As a result, for example, by performing the rolling readout for each pixel row and using the signal voltage read from the capacitor C2 and the reset voltage read from the capacitor C1, it is possible to remove a noise included in the signal voltage. Therefore, it is possible to suppress the generation of kTC noise.

In the present embodiment, the amplification section 11b is provided between the floating diffusion FD and the capacitor C1 in the signal path P1. This makes it possible to output the potential variation in the floating diffusion FD to the source of the amplification transistor AMP1 with little loss.

In addition, in the present embodiment, the pad electrode 35a and the pad electrode 42a are coupled to each other by being attached to each other. This makes it possible to shorten the signal path that electrically couples the light-receiving substrate 30 and the signal processing substrate 40 to each other, as compared with a case of coupling via bumps, for example. As a result, for example, it is possible to reduce a noise that enters the signal path from the outside.

### <2. Modification Examples>

Modification examples of the solid-state imaging device 1 according to the above embodiment are described below.

### [Modification Example A]

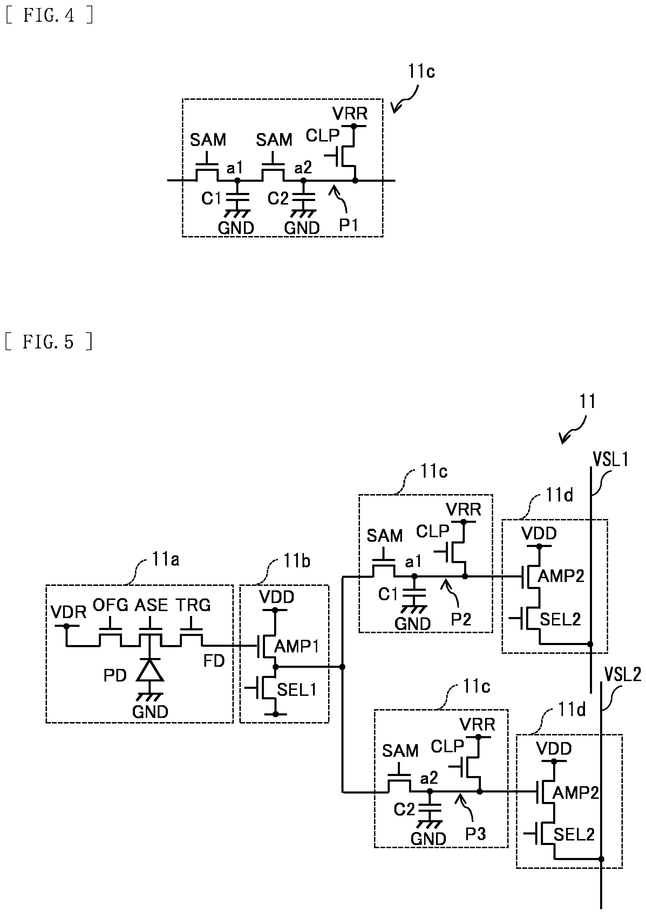

FIG. 4 illustrates a modification example of a circuit configuration of the S/H section 11c. In the embodiment described above, for example, as illustrated in FIG. 4, both of the two capacitors C1 and C2 provided in the S/H section 11c may be branched from and coupled to the signal path P1. Also in such a case, it is possible to cause the capacitor C1 to hold a reset voltage and to cause the capacitor C2 to hold a signal voltage. As a result, for example, by performing rolling readout for each pixel row and using the signal voltage read from the capacitor C2 and the reset voltage read from the capacitor C1, it is possible to remove a noise included in the signal voltage. Therefore, it is possible to suppress the generation of kTC noise.

In the present modification example, the amplification section 11b is provided between the floating diffusion FD and the capacitor C1 in the signal path P1. This makes it possible to output the potential variation in the floating diffusion FD to the source of the amplification transistor AMP1 with little loss.

### [Modification Example B]

FIG. 5 illustrates a modification example of a circuit configuration of the sensor pixel 11. In the embodiment described above, for example, as illustrated in FIG. 5, two S/H sections 11c and two readout sections 11d may be provided in the sensor pixel 11. At this time, one of the S/H sections 11c is provided with the capacitor C1, and another of the S/H sections 11c is provided with the capacitor C2. The capacitor C1 is branched from and coupled to a signal path P2 from the floating diffusion FD to one of the S/H sections 11c. The capacitor C2 is branched from and coupled to a signal path P3 from the floating diffusion FD to the other of the S/H sections 11c. Also in such a case, it is possible to cause the capacitor C1 to hold a reset voltage and to cause the capacitor C2 to hold a signal voltage. As a result, for example, by performing rolling readout for each pixel row and using the signal voltage read from the capacitor C2 and the reset voltage read from the capacitor C1, it is possible to remove a noise included in the signal voltage. Therefore, it is possible to suppress the generation of kTC noise.

In the present modification example, a path between the floating diffusion FD and the capacitor C1 in the signal path P2 and a path between the floating diffusion FD and the capacitor C2 in the signal path P3 further include a common path that is common to each other. The amplification section 11b is inserted into this common path. This makes it possible to reduce the circuit scale of the sensor pixel 11, as compared with a case where the amplification section 1 1b is provided for each of the capacitors C1 and C2. Further, by reducing the circuit scale of the sensor pixel 11, for example, it is possible to reduce a noise that enters the signal path from the outside.

### [Modification Example C]

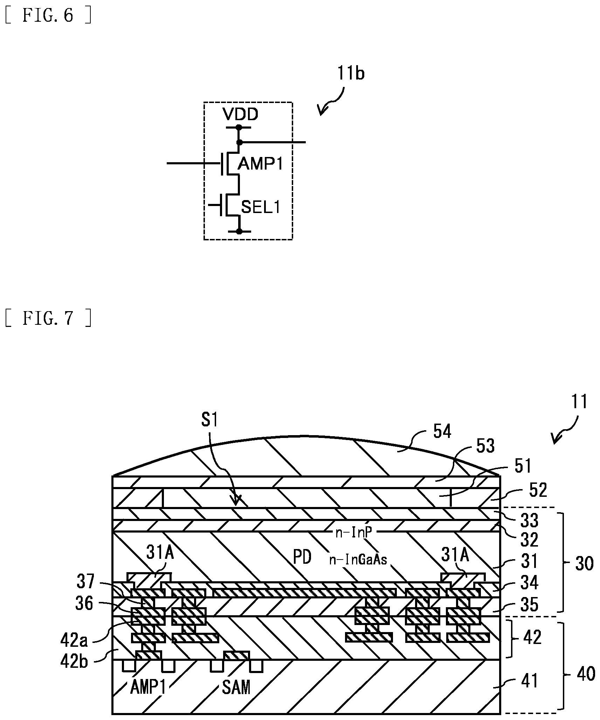

FIG. 6 illustrates a modification example of a circuit configuration of the amplification section 11b. In the embodiment described above and the modification examples thereof, for example, as illustrated in FIG. 6, the amplification section 11b may include a common source circuit. Also in such a case, it is possible to output the potential variation in the floating diffusion FD to the source of the amplification transistor AMP1 with little loss.

### [Modification Example D]

FIG. 7 illustrates a modification example of the cross-sectional configuration of the sensor pixel 11. In the embodiment described above and the modification examples thereof, for example, as illustrated in FIG. 7, a high-concentration impurity region 31A doped with high-concentration impurities may be provided in the semiconductor layer 31. For example, the high-concentration impurity region 31A is formed on a surface, of the semiconductor layer 31, to which the floating diffusion FD is exposed. For example, the high-concentration impurity region 31A is further disposed on a surface, of the semiconductor layer 31, to which the drain of the discharge transistor OFG is exposed. In this way, providing the high-concentration impurity region 31A in the semiconductor layer 31 makes it possible to enhance an ohmic contact between the semiconductor layer 31 (e.g., the floating diffusion FD or a drain of the discharge transistor OFG) and the coupling section 37.

### [Modification Example E]

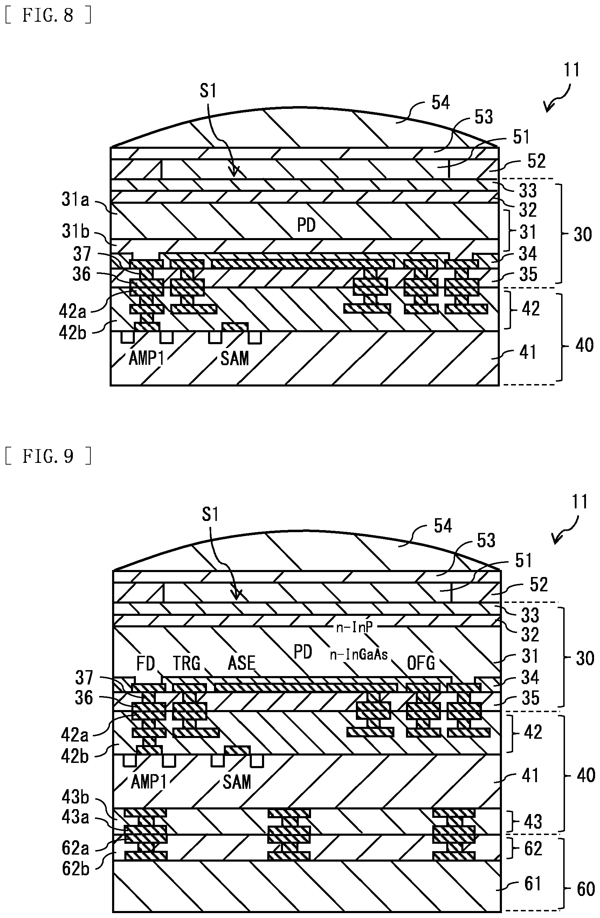

FIG. 8 illustrates a modification example of the cross-sectional configuration of the sensor pixel 11. In the embodiment described above and the modification examples thereof, for example, as illustrated in FIG. 8, the semiconductor layer 31 may include a semiconductor layer 31a in which the photodiode PD is formed and a semiconductor layer 31b provided between the semiconductor layer 31a and the insulating layer 34.

The semiconductor layer 31a is, for example, a layer including a material that is different from that of the Si substrate (described later) included in the signal processing substrate 40. The semiconductor layer 31a) is, for example, an InGaAs layer, an organic photoelectric conversion layer, a Ge layer, an SiGe layer, an amorphous silicon layer, or a quantum dot layer. The semiconductor layer 31b is a layer that transfers signal charge accumulated in the semiconductor layer 31a to the floating diffusion FD. The semiconductor layer 3 1b is also a layer that discharges the signal charge remaining in the semiconductor layer 31a to the drain of the discharge transistor OFG. The semiconductor layer 31b includes, for example, a semiconductor material having light transmissivity.

As described above, providing the semiconductor layer 31b makes it possible to efficiently transfer and discharge the signal charge. This makes it difficult for the signal charge to remain in the semiconductor layer 3 1b, thus making it possible to suppress generation of a noise due to the signal charge remaining in the semiconductor layer 31b.

### [Modification Example F]

FIG. 9 illustrates a modification example of the cross-sectional configuration of the sensor pixel 11. In the embodiment described above and the modification examples thereof, for example, as illustrated in FIG. 9, the sensor pixel 11 may further include a peripheral circuit substrate 60.

The peripheral circuit substrate 60 includes, for example, a semiconductor substrate 61. The semiconductor substrate 61 is, for example, an Si substrate. For example, the readout section 11d is formed in the semiconductor substrate 61. The amplification section 11b and the S/H section 11c (capacitors C1 and C2) are formed in the semiconductor substrate 41. The wiring layer 62 is stacked on a surface of the semiconductor substrate 61 on the side of the signal processing substrate 40. The wiring layer 62 includes, for example, a plurality of pad electrodes 62a, a plurality of wiring lines electrically coupling to each other the plurality of pad electrode 62a and the readout section 11d or the like, and an insulating layer 62b that insulates and isolates the plurality of pad electrodes 62a and the readout section 1 1d or the like from each other.

In the present modification example, a wiring layer 43 is stacked on a surface of the signal processing substrate 40 on a side of the peripheral circuit substrate 60. The wiring layer 43 includes, for example, a plurality of pad electrodes 43a, a plurality of wiring lines electrically coupling to each other the plurality of pad electrodes 43a and the S/H sections 11c (capacitors C1 and C2) or the like, and an insulating layer 43b that insulates and isolates the plurality of pad electrodes 43a and the S/H sections 11c (capacitors C1 and C2) or the like from each other. The plurality of pad electrodes 62a and the plurality of pad electrodes 43a are attached to each other by being bonded to each other.

As described above, providing the peripheral circuit substrate 60 enables a circuit layout of a circuit (e.g., the amplification section 11b or the S/H sections 11c (capacitors C1 and C2)) formed in the semiconductor substrate 41 of the signal processing substrate 40 to have more flexibility.

### [Modification Example G]

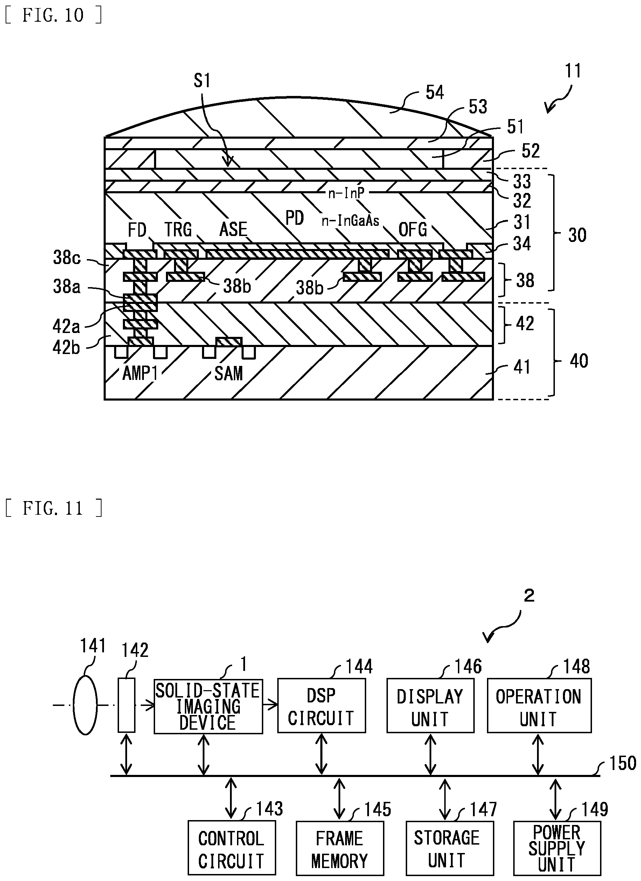

FIG. 10 illustrates a modification example of the cross-sectional configuration of the sensor pixel 11. In the embodiment described above and the modification examples thereof, for example, as illustrated in FIG. 10, a wiring layer 38 in contact with a surface of the light-receiving substrate 30 on the side of the signal processing substrate 40 may be further provided. In this case, the wiring layer 38 includes, for example, a plurality of pad electrodes 38a, a plurality of pixel drive lines 38b, and an insulating layer 38c that insulates and isolates the plurality of pad electrodes 38a and the plurality of pixel drive lines 38b from each other. The plurality of pad electrodes 38a and the plurality of pad electrodes 42a are bonded to each other by being attached to each other. The plurality of pixel drive lines 38b is coupled to gates of the discharge transistor OFG, the electric charge accumulation transistor ASE, and the transfer transistor TRG. The plurality of pixel drive lines 38b is further coupled to the vertical drive circuit 21.

Thus, providing the wiring layer 38 makes it unnecessary to provide the plurality of pixel drive lines 38b in the wiring layer 42 of the signal processing substrate 40. This makes it possible to reduce the number of pad electrodes that bond the light-receiving substrate 30 and the signal processing substrate 40 to each other, as compared with a case where the wiring layer 38 is not provided. As a result, it is possible to reduce a size of the sensor pixel 11.

### <3. Application Example>

The solid-state imaging device 1 according to any of the embodiment described above and the modification examples thereof is applicable in general to any electronic apparatus using a solid-state imaging element in an image capturing section, such as an imaging apparatus such as a digital still camera or a video camera, a portable terminal apparatus having an imaging function, and a copying machine using a solid-state imaging element in an image reading section. Further, an embodiment of the present disclosure is also applicable to a robot, a drone, an automobile, medical equipment (endoscope), or the like, including the solid-state imaging device 1. It is to be noted that the solid-state imaging device 1 according to any of the embodiment described above and the modification examples thereof may be in the form in which the device is formed as one chip, or may be in the module-like form having an imaging function in which an imaging section and a signal processing section or an optical system are packaged together as one. An example of an imaging system including the solid-state imaging device 1 according to any of the embodiment described above and the modification examples thereof are described below with reference to FIG. 11. FIG. 11 is an explanatory diagram illustrating an example of an imaging system 2 including the solid-state imaging device 1 according to any of the embodiment described above and the modification examples thereof.

As illustrated in FIG. 11, the imaging system 2 includes, for example, the solid-state imaging device 1 according to any of the embodiment described above and the modification examples thereof, an optical system 141, a shutter device 142, a control circuit 143, a DSP circuit 144, a frame memory 145, a display unit 146, a storage unit 147, an operation unit 148, and a power supply unit 149. In the imaging system 2, the solid-state imaging device 1 according to any of the embodiment described above and the modification examples thereof, the DSP circuit 144, the frame memory 145, the display unit 146, the storage unit 147, the operation unit 148, and the power supply unit 149 are coupled to each other through a bus line 150.

The optical system 141 includes one or a plurality of lenses. The optical system 141 guides light (incident light) from a subject to the solid-state imaging device 1 to form an image on a light receiving surface of the solid-state imaging device 1. The shutter device 142 is disposed between the optical system 141 and the solid-state imaging device 1, and controls a period in which the solid-state imaging device 1 is irradiated with light and a period in which light is blocked under the control of the control circuit 143. The solid-state imaging device 1 accumulates a signal charge for a certain period in accordance with light of an image formed on the light receiving surface through the optical system 141 and the shutter device 142. The signal charge accumulated in the solid-state imaging device 1 is transferred to the DSP circuit 144 as a pixel signal (image data) in accordance with a drive signal (timing signal) supplied from the control circuit 143. In other words, the solid-state imaging device 1 receives image light (incident light) coming through the optical system 141 and the shutter device 142, and outputs the pixel signal corresponding to the received image light (incident light) to the DSP circuit 144. The control circuit 143 outputs drive signals for controlling a transfer operation of the solid-state imaging device 1 and a shutter operation of the shutter device 142, and drives the solid-state imaging device 1 and the shutter device 142.

The DSP circuit 144 is a signal processing circuit that processes the pixel signal (image data) outputted from the solid-state imaging device 1. The frame memory 145 temporarily holds the image data processed by the DSP circuit 144 in a unit of frames. The display unit 146 includes, for example, a panel-type display device such as a liquid crystal panel or an organic EL (Electro Luminescence) panel, and displays a moving image or a still image captured by the solid-state imaging device 1. The storage unit 147 records the image data of the moving image or the still image captured by the solid-state imaging device 1 in a recording medium such as a semiconductor memory or a hard disk. The operation unit 148 issues an operation instruction for a variety of functions of the imaging system 2 in accordance with an operation performed by a user. The power supply unit 149 appropriately supplies various kinds of power for operation to the solid-state imaging device 1, the DSP circuit 144, the frame memory 145, the display unit 146, the storage unit 147, and the operation unit 148 which are supply targets.

In the present application example, the solid-state imaging device 1 according to any of the embodiment described above and the modification examples thereof is applied to the imaging system 2. This makes it possible to reduce a size of the solid-state imaging device 1 or to make the solid-state imaging device 1 have high definition, thus making it possible to provide a small-sized or high-definition imaging system 2.

### <4. Practical Application Examples>

### [Practical Application Example 1]

The technology according to the present disclosure (the present technology) is applicable to a variety of products. For example, the technology according to the present disclosure may be achieved as a device mounted on any type of mobile body such as an automobile, an electric vehicle, a hybrid electric vehicle, a motorcycle, a bicycle, a personal mobility, an airplane, a drone, a vessel, or a robot.

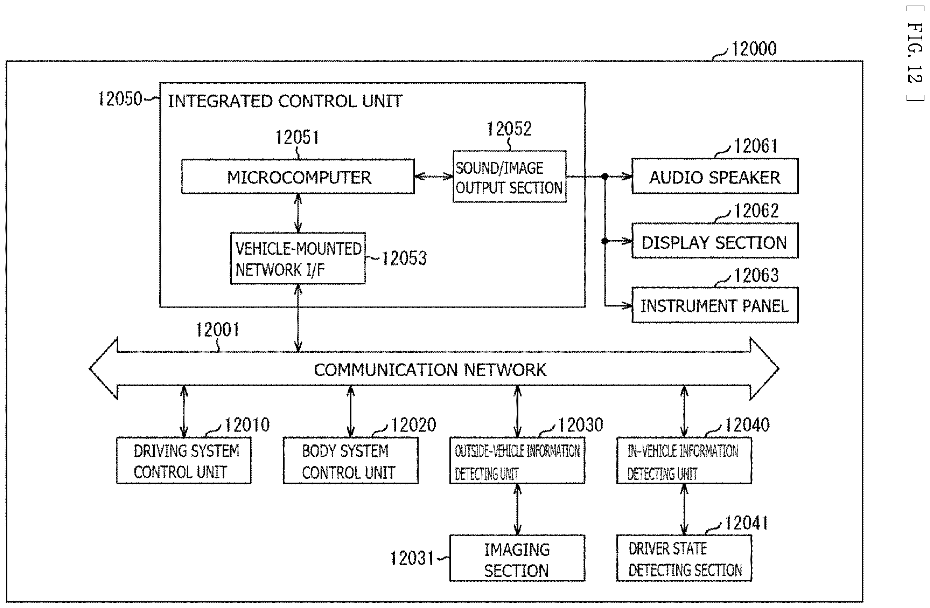

FIG. 12 is a block diagram depicting an example of schematic configuration of a vehicle control system as an example of a mobile body control system to which the technology according to an embodiment of the present disclosure can be applied.

The vehicle control system 12000 includes a plurality of electronic control units connected to each other via a communication network 12001. In the example depicted in FIG. 12, the vehicle control system 12000 includes a driving system control unit 12010, a body system control unit 12020, an outside-vehicle information detecting unit 12030, an in-vehicle information detecting unit 12040, and an integrated control unit 12050. In addition, a microcomputer 12051, a sound/image output section 12052, and a vehicle-mounted network interface (I/F) 12053 are illustrated as a functional configuration of the integrated control unit 12050.

The driving system control unit 12010 controls the operation of devices related to the driving system of the vehicle in accordance with various kinds of programs. For example, the driving system control unit 12010 functions as a control device for a driving force generating device for generating the driving force of the vehicle, such as an internal combustion engine, a driving motor, or the like, a driving force transmitting mechanism for transmitting the driving force to wheels, a steering mechanism for adjusting the steering angle of the vehicle, a braking device for generating the braking force of the vehicle, and the like.

The body system control unit 12020 controls the operation of various kinds of devices provided to a vehicle body in accordance with various kinds of programs. For example, the body system control unit 12020 functions as a control device for a keyless entry system, a smart key system, a power window device, or various kinds of lamps such as a headlamp, a backup lamp, a brake lamp, a turn signal, a fog lamp, or the like. In this case, radio waves transmitted from a mobile device as an alternative to a key or signals of various kinds of switches can be input to the body system control unit 12020. The body system control unit 12020 receives these input radio waves or signals, and controls a door lock device, the power window device, the lamps, or the like of the vehicle.

The outside-vehicle information detecting unit 12030 detects information about the outside of the vehicle including the vehicle control system 12000. For example, the outside-vehicle information detecting unit 12030 is connected with an imaging section 12031. The outside-vehicle information detecting unit 12030 makes the imaging section 12031 image an image of the outside of the vehicle, and receives the imaged image. On the basis of the received image, the outside-vehicle information detecting unit 12030 may perform processing of detecting an object such as a human, a vehicle, an obstacle, a sign, a character on a road surface, or the like, or processing of detecting a distance thereto.

The imaging section 12031 is an optical sensor that receives light, and which outputs an electric signal corresponding to a received light amount of the light. The imaging section 12031 can output the electric signal as an image, or can output the electric signal as information about a measured distance. In addition, the light received by the imaging section 12031 may be visible light, or may be invisible light such as infrared rays or the like.

The in-vehicle information detecting unit 12040 detects information about the inside of the vehicle. The in-vehicle information detecting unit 12040 is, for example, connected with a driver state detecting section 12041 that detects the state of a driver. The driver state detecting section 12041, for example, includes a camera that images the driver. On the basis of detection information input from the driver state detecting section 12041, the in-vehicle information detecting unit 12040 may calculate a degree of fatigue of the driver or a degree of concentration of the driver, or may determine whether the driver is dozing.

The microcomputer 12051 can calculate a control target value for the driving force generating device, the steering mechanism, or the braking device on the basis of the information about the inside or outside of the vehicle which information is obtained by the outside-vehicle information detecting unit 12030 or the in-vehicle information detecting unit 12040, and output a control command to the driving system control unit 12010. For example, the microcomputer 12051 can perform cooperative control intended to implement functions of an advanced driver assistance system (ADAS) which functions include collision avoidance or shock mitigation for the vehicle, following driving based on a following distance, vehicle speed maintaining driving, a warning of collision of the vehicle, a warning of deviation of the vehicle from a lane, or the like.

In addition, the microcomputer 12051 can perform cooperative control intended for automated driving, which makes the vehicle to travel automatedly without depending on the operation of the driver, or the like, by controlling the driving force generating device, the steering mechanism, the braking device, or the like on the basis of the information about the outside or inside of the vehicle which information is obtained by the outside-vehicle information detecting unit 12030 or the in-vehicle information detecting unit 12040.

In addition, the microcomputer 12051 can output a control command to the body system control unit 12020 on the basis of the information about the outside of the vehicle which information is obtained by the outside-vehicle information detecting unit 12030. For example, the microcomputer 12051 can perform cooperative control intended to prevent a glare by controlling the headlamp so as to change from a high beam to a low beam, for example, in accordance with the position of a preceding vehicle or an oncoming vehicle detected by the outside-vehicle information detecting unit 12030.

The sound/image output section 12052 transmits an output signal of at least one of a sound and an image to an output device capable of visually or auditorily notifying information to an occupant of the vehicle or the outside of the vehicle. In the example of FIG. 12, an audio speaker 12061, a display section 12062, and an instrument panel 12063 are illustrated as the output device. The display section 12062 may, for example, include at least one of an on-board display and a head-up display.

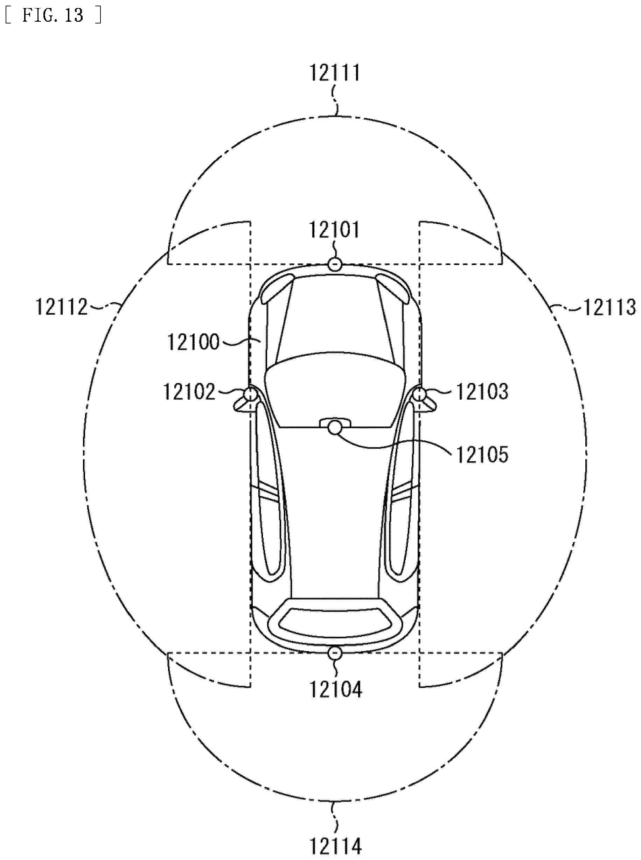

FIG. 13 is a diagram depicting an example of the installation position of the imaging section 12031.

In FIG. 13, the imaging section 12031 includes imaging sections 12101, 12102, 12103, 12104, and 12105.

The imaging sections 12101, 12102, 12103, 12104, and 12105 are, for example, disposed at positions on a front nose, sideview mirrors, a rear bumper, and a back door of the vehicle 12100 as well as a position on an upper portion of a windshield within the interior of the vehicle. The imaging section 12101 provided to the front nose and the imaging section 12105 provided to the upper portion of the windshield within the interior of the vehicle obtain mainly an image of the front of the vehicle 12100. The imaging sections 12102 and 12103 provided to the sideview mirrors obtain mainly an image of the sides of the vehicle 12100. The imaging section 12104 provided to the rear bumper or the back door obtains mainly an image of the rear of the vehicle 12100. The imaging section 12105 provided to the upper portion of the windshield within the interior of the vehicle is used mainly to detect a preceding vehicle, a pedestrian, an obstacle, a signal, a traffic sign, a lane, or the like.

Incidentally, FIG. 13 depicts an example of photographing ranges of the imaging sections 12101 to 12104. An imaging range 12111 represents the imaging range of the imaging section 12101 provided to the front nose. Imaging ranges 12112 and 12113 respectively represent the imaging ranges of the imaging sections 12102 and 12103 provided to the sideview mirrors. An imaging range 12114 represents the imaging range of the imaging section 12104 provided to the rear bumper or the back door. A bird's-eye image of the vehicle 12100 as viewed from above is obtained by superimposing image data imaged by the imaging sections 12101 to 12104, for example.

At least one of the imaging sections 12101 to 12104 may have a function of obtaining distance information. For example, at least one of the imaging sections 12101 to 12104 may be a stereo camera constituted of a plurality of imaging elements, or may be an imaging element having pixels for phase difference detection.

For example, the microcomputer 12051 can determine a distance to each three-dimensional object within the imaging ranges 12111 to 12114 and a temporal change in the distance (relative speed with respect to the vehicle 12100) on the basis of the distance information obtained from the imaging sections 12101 to 12104, and thereby extract, as a preceding vehicle, a nearest three-dimensional object in particular that is present on a traveling path of the vehicle 12100 and which travels in substantially the same direction as the vehicle 12100 at a predetermined speed (for example, equal to or more than 0 km/hour). Further, the microcomputer 12051 can set a following distance to be maintained in front of a preceding vehicle in advance, and perform automatic brake control (including following stop control), automatic acceleration control (including following start control), or the like. It is thus possible to perform cooperative control intended for automated driving that makes the vehicle travel automatedly without depending on the operation of the driver or the like.

For example, the microcomputer 12051 can classify three-dimensional object data on three-dimensional objects into three-dimensional object data of a two-wheeled vehicle, a standard-sized vehicle, a large-sized vehicle, a pedestrian, a utility pole, and other three-dimensional objects on the basis of the distance information obtained from the imaging sections 12101 to 12104, extract the classified three-dimensional object data, and use the extracted three-dimensional object data for automatic avoidance of an obstacle. For example, the microcomputer 12051 identifies obstacles around the vehicle 12100 as obstacles that the driver of the vehicle 12100 can recognize visually and obstacles that are difficult for the driver of the vehicle 12100 to recognize visually. Then, the microcomputer 12051 determines a collision risk indicating a risk of collision with each obstacle. In a situation in which the collision risk is equal to or higher than a set value and there is thus a possibility of collision, the microcomputer 12051 outputs a warning to the driver via the audio speaker 12061 or the display section 12062, and performs forced deceleration or avoidance steering via the driving system control unit 12010. The microcomputer 12051 can thereby assist in driving to avoid collision.

At least one of the imaging sections 12101 to 12104 may be an infrared camera that detects infrared rays. The microcomputer 12051 can, for example, recognize a pedestrian by determining whether or not there is a pedestrian in imaged images of the imaging sections 12101 to 12104. Such recognition of a pedestrian is, for example, performed by a procedure of extracting characteristic points in the imaged images of the imaging sections 12101 to 12104 as infrared cameras and a procedure of determining whether or not it is the pedestrian by performing pattern matching processing on a series of characteristic points representing the contour of the object. When the microcomputer 12051 determines that there is a pedestrian in the imaged images of the imaging sections 12101 to 12104, and thus recognizes the pedestrian, the sound/image output section 12052 controls the display section 12062 so that a square contour line for emphasis is displayed so as to be superimposed on the recognized pedestrian. The sound/image output section 12052 may also control the display section 12062 so that an icon or the like representing the pedestrian is displayed at a desired position.

The above has described the example of the mobile body control system to which the technology according to the present disclosure may be applied. The technology according to the present disclosure may be applied to the imaging section 12031 among the components described above. Specifically, the solid-state imaging device 1 according to any of the embodiment described above and the modification examples thereof is applicable to the imaging section 12031. The application of the technology according to the present disclosure to the imaging section 12031 makes it possible to obtain a high-sensitively captured image, thus enabling the mobile body control system to perform high-accuracy control using the captured image.

### [Practical Application Example 2]

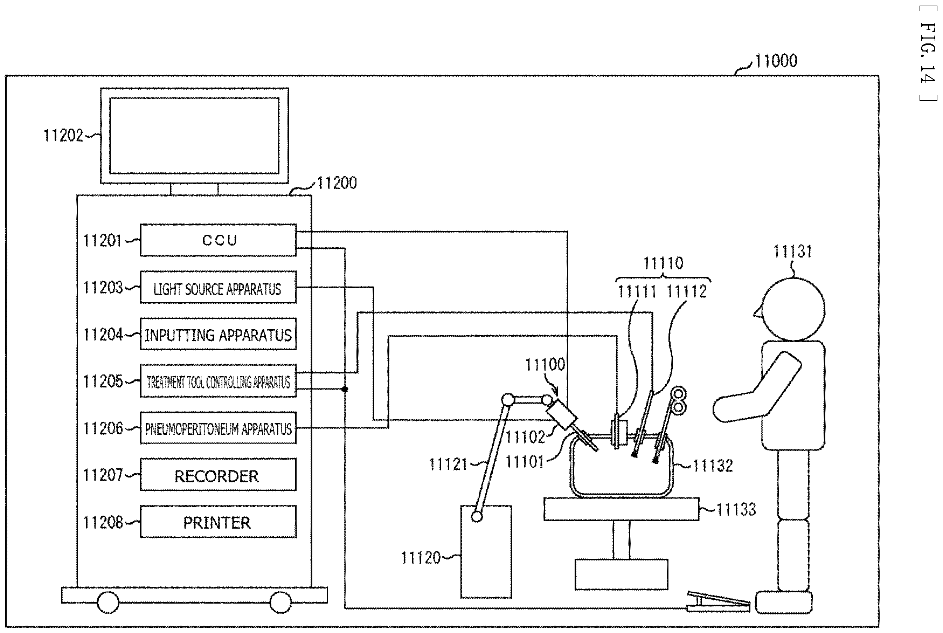

FIG. 14 is a view depicting an example of a schematic configuration of an endoscopic surgery system to which the technology according to an embodiment of the present disclosure (present technology) can be applied.

In FIG. 14, a state is illustrated in which a surgeon (medical doctor) 11131 is using an endoscopic surgery system 11000 to perform surgery for a patient 11132 on a patient bed 11133. As depicted, the endoscopic surgery system 11000 includes an endoscope 11100, other surgical tools 11110 such as a pneumoperitoneum tube 11111 and an energy device 11112, a supporting arm apparatus 11120 which supports the endoscope 11100 thereon, and a cart 11200 on which various apparatus for endoscopic surgery are mounted.

The endoscope 11100 includes a lens barrel 11101 having a region of a predetermined length from a distal end thereof to be inserted into a body cavity of the patient 11132, and a camera head 11102 connected to a proximal end of the lens barrel 11101. In the example depicted, the endoscope 11100 is depicted which includes as a rigid endoscope having the lens barrel 11101 of the hard type. However, the endoscope 11100 may otherwise be included as a flexible endoscope having the lens barrel 11101 of the flexible type.

The lens barrel 11101 has, at a distal end thereof, an opening in which an objective lens is fitted. A light source apparatus 11203 is connected to the endoscope 11100 such that light generated by the light source apparatus 11203 is introduced to a distal end of the lens barrel 11101 by a light guide extending in the inside of the lens barrel 11101 and is irradiated toward an observation target in a body cavity of the patient 11132 through the objective lens. It is to be noted that the endoscope 11100 may be a forward-viewing endoscope or may be an oblique-viewing endoscope or a side-viewing endoscope.

An optical system and an image pickup element are provided in the inside of the camera head 11102 such that reflected light (observation light) from the observation target is condensed on the image pickup element by the optical system. The observation light is photoelectrically converted by the image pickup element to generate an electric signal corresponding to the observation light, namely, an image signal corresponding to an observation image. The image signal is transmitted as RAW data to a CCU 11201.

The CCU 11201 includes a central processing unit (CPU), a graphics processing unit (GPU) or the like and integrally controls operation of the endoscope 11100 and a display apparatus 11202. Further, the CCU 11201 receives an image signal from the camera head 11102 and performs, for the image signal, various image processes for displaying an image based on the image signal such as, for example, a development process (demosaic process).

The display apparatus 11202 displays thereon an image based on an image signal, for which the image processes have been performed by the CCU 11201, under the control of the CCU 11201.

The light source apparatus 11203 includes a light source such as, for example, a light emitting diode (LED) and supplies irradiation light upon imaging of a surgical region to the endoscope 11100.

An inputting apparatus 11204 is an input interface for the endoscopic surgery system 11000. A user can perform inputting of various kinds of information or instruction inputting to the endoscopic surgery system 11000 through the inputting apparatus 11204. For example, the user would input an instruction or a like to change an image pickup condition (type of irradiation light, magnification, focal distance or the like) by the endoscope 11100.

A treatment tool controlling apparatus 11205 controls driving of the energy device 11112 for cautery or incision of a tissue, sealing of a blood vessel or the like. A pneumoperitoneum apparatus 11206 feeds gas into a body cavity of the patient 11132 through the pneumoperitoneum tube 11111 to inflate the body cavity in order to secure the field of view of the endoscope 11100 and secure the working space for the surgeon. A recorder 11207 is an apparatus capable of recording various kinds of information relating to surgery. A printer 11208 is an apparatus capable of printing various kinds of information relating to surgery in various forms such as a text, an image or a graph.

It is to be noted that the light source apparatus 11203 which supplies irradiation light when a surgical region is to be imaged to the endoscope 11100 may include a white light source which includes, for example, an LED, a laser light source or a combination of them. Where a white light source includes a combination of red, green, and blue (RGB) laser light sources, since the output intensity and the output timing can be controlled with a high degree of accuracy for each color (each wavelength), adjustment of the white balance of a picked up image can be performed by the light source apparatus 11203. Further, in this case, if laser beams from the respective RGB laser light sources are irradiated time-divisionally on an observation target and driving of the image pickup elements of the camera head 11102 are controlled in synchronism with the irradiation timings. Then images individually corresponding to the R, G and B colors can be also picked up time-divisionally. According to this method, a color image can be obtained even if color filters are not provided for the image pickup element.

Further, the light source apparatus 11203 may be controlled such that the intensity of light to be outputted is changed for each predetermined time. By controlling driving of the image pickup element of the camera head 11102 in synchronism with the timing of the change of the intensity of light to acquire images time-divisionally and synthesizing the images, an image of a high dynamic range free from underexposed blocked up shadows and overexposed highlights can be created.

Further, the light source apparatus 11203 may be configured to supply light of a predetermined wavelength band ready for special light observation. In special light observation, for example, by utilizing the wavelength dependency of absorption of light in a body tissue to irradiate light of a narrow band in comparison with irradiation light upon ordinary observation (namely, white light), narrow band observation (narrow band imaging) of imaging a predetermined tissue such as a blood vessel of a superficial portion of the mucous membrane or the like in a high contrast is performed. Alternatively, in special light observation, fluorescent observation for obtaining an image from fluorescent light generated by irradiation of excitation light may be performed. In fluorescent observation, it is possible to perform observation of fluorescent light from a body tissue by irradiating excitation light on the body tissue (autofluorescence observation) or to obtain a fluorescent light image by locally injecting a reagent such as indocyanine green (ICG) into a body tissue and irradiating excitation light corresponding to a fluorescent light wavelength of the reagent upon the body tissue. The light source apparatus 11203 can be configured to supply such narrow-band light and/or excitation light suitable for special light observation as described above.

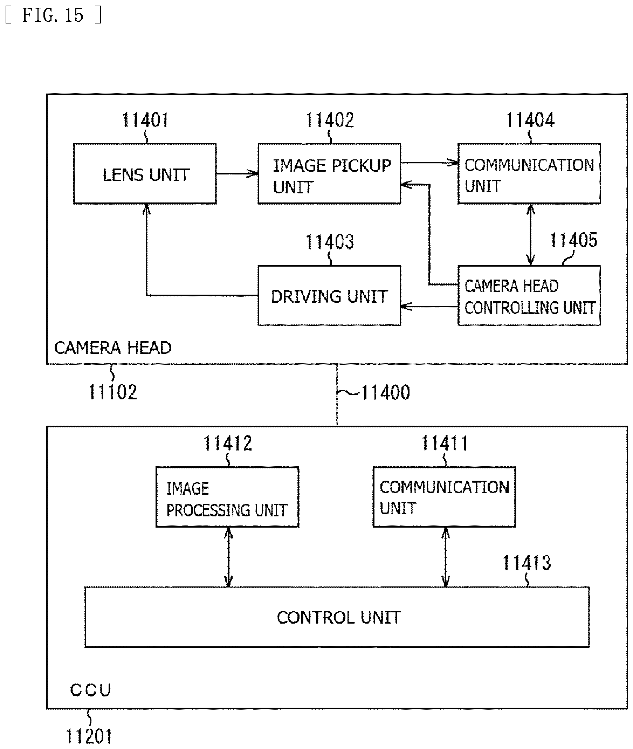

FIG. 15 is a block diagram depicting an example of a functional configuration of the camera head 11102 and the CCU 11201 depicted in FIG. 14.

The camera head 11102 includes a lens unit 11401, an image pickup unit 11402, a driving unit 11403, a communication unit 11404 and a camera head controlling unit 11405. The CCU 11201 includes a communication unit 11411, an image processing unit 11412 and a control unit 11413. The camera head 11102 and the CCU 11201 are connected for communication to each other by a transmission cable 11400.

The lens unit 11401 is an optical system, provided at a connecting location to the lens barrel 11101. Observation light taken in from a distal end of the lens barrel 11101 is guided to the camera head 11102 and introduced into the lens unit 11401. The lens unit 11401 includes a combination of a plurality of lenses including a zoom lens and a focusing lens.

The number of image pickup elements which is included by the image pickup unit 11402 may be one (single-plate type) or a plural number (multi-plate type). Where the image pickup unit 11402 is configured as that of the multi-plate type, for example, image signals corresponding to respective R, G and B are generated by the image pickup elements, and the image signals may be synthesized to obtain a color image. The image pickup unit 11402 may also be configured so as to have a pair of image pickup elements for acquiring respective image signals for the right eye and the left eye ready for three dimensional (3D) display. If 3D display is performed, then the depth of a living body tissue in a surgical region can be comprehended more accurately by the surgeon 11131. It is to be noted that, where the image pickup unit 11402 is configured as that of stereoscopic type, a plurality of systems of lens units 11401 are provided corresponding to the individual image pickup elements.

Further, the image pickup unit 11402 may not necessarily be provided on the camera head 11102. For example, the image pickup unit 11402 may be provided immediately behind the objective lens in the inside of the lens barrel 11101.

The driving unit 11403 includes an actuator and moves the zoom lens and the focusing lens of the lens unit 11401 by a predetermined distance along an optical axis under the control of the camera head controlling unit 11405. Consequently, the magnification and the focal point of a picked up image by the image pickup unit 11402 can be adjusted suitably.

The communication unit 11404 includes a communication apparatus for transmitting and receiving various kinds of information to and from the CCU 11201. The communication unit 11404 transmits an image signal acquired from the image pickup unit 11402 as RAW data to the CCU 11201 through the transmission cable 11400.

In addition, the communication unit 11404 receives a control signal for controlling driving of the camera head 11102 from the CCU 11201 and supplies the control signal to the camera head controlling unit 11405. The control signal includes information relating to image pickup conditions such as, for example, information that a frame rate of a picked up image is designated, information that an exposure value upon image picking up is designated and/or information that a magnification and a focal point of a picked up image are designated.

It is to be noted that the image pickup conditions such as the frame rate, exposure value, magnification or focal point may be designated by the user or may be set automatically by the control unit 11413 of the CCU 11201 on the basis of an acquired image signal. In the latter case, an auto exposure (AE) function, an auto focus (AF) function and an auto white balance (AWB) function are incorporated in the endoscope 11100.

The camera head controlling unit 11405 controls driving of the camera head 11102 on the basis of a control signal from the CCU 11201 received through the communication unit 11404.

The communication unit 11411 includes a communication apparatus for transmitting and receiving various kinds of information to and from the camera head 11102. The communication unit 11411 receives an image signal transmitted thereto from the camera head 11102 through the transmission cable 11400.

Further, the communication unit 11411 transmits a control signal for controlling driving of the camera head 11102 to the camera head 11102. The image signal and the control signal can be transmitted by electrical communication, optical communication or the like.

The image processing unit 11412 performs various image processes for an image signal in the form of RAW data transmitted thereto from the camera head 11102.

The control unit 11413 performs various kinds of control relating to image picking up of a surgical region or the like by the endoscope 11100 and display of a picked up image obtained by image picking up of the surgical region or the like. For example, the control unit 11413 creates a control signal for controlling driving of the camera head 11102.

Further, the control unit 11413 controls, on the basis of an image signal for which image processes have been performed by the image processing unit 11412, the display apparatus 11202 to display a picked up image in which the surgical region or the like is imaged. Thereupon, the control unit 11413 may recognize various objects in the picked up image using various image recognition technologies. For example, the control unit 11413 can recognize a surgical tool such as forceps, a particular living body region, bleeding, mist when the energy device 11112 is used and so forth by detecting the shape, color and so forth of edges of objects included in a picked up image. The control unit 11413 may cause, when it controls the display apparatus 11202 to display a picked up image, various kinds of surgery supporting information to be displayed in an overlapping manner with an image of the surgical region using a result of the recognition. Where surgery supporting information is displayed in an overlapping manner and presented to the surgeon 1113 1, the burden on the surgeon 11131 can be reduced and the surgeon 11131 can proceed with the surgery with certainty.

The transmission cable 11400 which connects the camera head 11102 and the CCU 11201 to each other is an electric signal cable ready for communication of an electric signal, an optical fiber ready for optical communication or a composite cable ready for both of electrical and optical communications.

Here, while, in the example depicted, communication is performed by wired communication using the transmission cable 11400, the communication between the camera head 11102 and the CCU 11201 may be performed by wireless communication.

The above has described the example of the endoscopic surgery system to which the technology according to the present disclosure may be applied. The technology according to the present disclosure may be favorably applied to the image pickup unit 11402 provided to the camera head 11102 of the endoscope 11100 among the components described above. The application of the technology according to the present disclosure to the image pickup unit 11402 makes it possible to obtain a high-sensitively captured image, thus making it possible to provide a high-definition endoscope 11100.

Although the present disclosure has been described above with reference to the embodiment, the modification examples thereof, the application example thereof, and the practical application examples thereof, the present disclosure is not limited to the embodiment and the like described above, and may be modified in a wide variety of ways. It is to be noted that the effects described herein is merely exemplary. The effects of the present disclosure are not limited to the effects described herein. The present disclosure may have effects other than the effects described herein.

In addition, the present disclosure may also have the following configurations.
(1)
   A solid-state imaging device including:
   a semiconductor layer stacked on a first Si substrate, and including a photoelectric conversion region that has a predetermined wavelength selectivity and a floating diffusion region that converts electric charge transferred from the photoelectric conversion region into an electric signal and outputs the electric signal;
   a first capacitor section formed in the first Si substrate, and holding a reset voltage of the floating diffusion region at a time when a voltage of the floating diffusion region is reset; and
   a second capacitor section formed in the first Si substrate, and holding a signal voltage generated by the electric signal.
(2) The solid-state imaging device according to (1), further including
   a readout section that reads the reset voltage from the first capacitor section and the signal voltage from the second capacitor section, in which
   the first capacitor section and the second capacitor section are branched from and coupled to a signal path from the floating diffusion region to the readout section.
(3) The solid-state imaging device according to (1), further including
   a readout section that reads the reset voltage from the first capacitor section and the signal voltage from the second capacitor section, in which
   the first capacitor section is branched from and coupled to a signal path from the floating diffusion region to the readout section, and
   the second capacitor section is inserted in series into the signal path.
(4) The solid-state imaging device according to (1), further including:
   a first readout section that reads the reset voltage from first capacitor section; and
   a second readout section that reads the signal voltage from the second capacitor section, in which
   the first capacitor section is branched from and coupled to a first signal path from the floating diffusion region to the first readout section, and
   the second capacitor section is branched from and coupled to a second signal path from the floating diffusion region to the second readout section.
(5) The solid-state imaging device according to (2), further including an amplifying circuit between the floating diffusion region and the first capacitor section and between the floating diffusion region and the second capacitor section in the signal path, the amplifying circuit amplifying the electric signal.
(6) The solid-state imaging device according to (3), further including an amplifying circuit between the floating diffusion region and the first capacitor section and between the floating diffusion region and the second capacitor section in the signal path, the amplifying circuit amplifying the electric signal.
(7) The solid-state imaging device according to (4), in which
   a path between the floating diffusion region and the first capacitor section in the first signal path and a path between the floating diffusion region and the second capacitor section in the second signal path have a common path common to each other, and
   the solid-state imaging device further includes a circuit inserted into the common path, the circuit amplifying the electric signal.
(8) The solid-state imaging device according to any one of (1) to (7), in which the photoelectric conversion region is formed in an InGaAs layer.
(9) The solid-state imaging device according to any one of (1) to (7), in which the photoelectric conversion region is formed in an organic photoelectric conversion layer, a Ge layer, an SiGe layer, an amorphous silicon layer, or a quantum dot layer.
(10) The solid-state imaging device according to any one of (1) to (9), further including:
   a first pad electrode formed on a surface of the semiconductor layer on a side of the first Si substrate, and being electrically coupled to the floating diffusion region; and
   a second pad electrode formed on a surface of the first Si substrate on a side of the semiconductor layer, and being electrically coupled to the first capacitor section and the second capacitor section, in which
   the first pad electrode and the second pad electrode are coupled to each other by being attached to each other.
(11) The solid-state imaging device according to (2), in which the readout section is formed in the first Si substrate.
(12) The solid-state imaging device according to (3), in which the readout section is formed in the first Si substrate.
(13) The solid-state imaging device according to (4), in which the first readout section and the second readout section are formed in the first Si substrate.
(14) The solid-state imaging device according to (2), further including:
   a second Si substrate including the readout section, and being provided separately from the first Si substrate;
   a third pad electrode formed on a surface of the first Si substrate on a side of the second Si substrate, and being electrically coupled to the first capacitor section and the second capacitor section; and
   a fourth pad electrode formed on a surface of the second Si substrate on a side of the first Si substrate, and being electrically coupled to the readout section, in which
   the third pad electrode and the fourth pad electrode are coupled to each other by being attached to each other.
(15) The solid-state imaging device according to (3), further including:
   a second Si substrate including the readout section, and being provided separately from the first Si substrate;
   a third pad electrode formed on a surface of the first Si substrate on a side of the second Si substrate, and being electrically coupled to the first capacitor section and the second capacitor section; and
   a fourth pad electrode formed on a surface of the second Si substrate on a side of the first Si substrate, and being electrically coupled to the readout section, in which
   the third pad electrode and the fourth pad electrode are coupled to each other by being attached to each other.
(16) The solid-state imaging device according to (4), further including:
   a second Si substrate including the first readout section and the second readout section, and being provided separately from the first Si substrate;
   a fifth pad electrode formed on a surface of the first Si substrate on a side of the second Si substrate, and being electrically coupled to the first capacitor section;
   a sixth pad electrode formed on the surface of the first Si substrate on the side of the second Si substrate, and being electrically coupled to the second capacitor section;
   a seventh pad electrode formed on a surface of the second Si substrate on a side of the first Si substrate, and being electrically coupled to the first readout section; and
   an eighth pad electrode formed on the surface of the second Si substrate on the side of the first Si substrate, and being electrically coupled to the second readout section, in which
   the fifth pad electrode and the seventh pad electrode are bonded to each other by being attached to each other, and
   the sixth pad electrode and the eighth pad electrode are bonded to each other by being attached to each other.
(17) An electronic apparatus including a solid-state imaging device, in which
   the solid-state imaging device includes
   a semiconductor layer stacked on a first Si substrate, and including a photoelectric conversion region that has a predetermined wavelength selectivity and a floating diffusion region that converts electric charge transferred from the photoelectric conversion region into an electric signal and outputs the electric signal,
   a first capacitor section formed in the first Si substrate, and holding a reset voltage of the floating diffusion region at a time when a voltage of the floating diffusion region is reset, and
   a second capacitor section formed in the first Si substrate, and holding a signal voltage generated by the electric signal.
(18) A mobile body including a solid-state imaging device, in which
   the solid-state imaging device includes
   a semiconductor layer stacked on a first Si substrate, and including a photoelectric conversion region that has a predetermined wavelength selectivity and a floating diffusion region that converts electric charge transferred from the photoelectric conversion region into an electric signal and outputs the electric signal,
   a first capacitor section formed in the first Si substrate, and holding a reset voltage of the floating diffusion region at a time when a voltage of the floating diffusion region is reset, and
   a second capacitor section formed in the first Si substrate, and holding a signal voltage generated by the electric signal.

In the solid-state imaging device, the electronic apparatus, and the mobile body according to the embodiment of the present disclosure, two capacitor sections (a first capacitor section and a second capacitor section) are formed in the Si substrate. Thus, for example, by determining a difference between the reset voltage that is held in the first capacitor section and the signal voltage that is held in the second capacitor section, it is possible to remove a noise included in the signal voltage. As a result, it is possible to suppress the generation of kTC noise. In addition, in the present disclosure, the semiconductor layer is provided with the floating diffusion region separately from the photoelectric conversion region, and electric charge generated in the floating diffusion region is transferred to the floating diffusion region. Here, it is possible to remove a noise by the two capacitor sections provided at the subsequent stage of the floating diffusion region, thus making it possible to reduce the capacitance of the floating diffusion region. This increases the conversion efficiency and improves SN. Therefore, it is possible to adopt the global shutter method while obtaining a high SN ratio.

This application claims the benefit of Japanese Priority Patent Application JP2021-077975 filed with the Japan Patent Office on April 30, 2021, the entire contents of which are incorporated herein by reference.

It should be understood by those skilled in the art that various modifications, combinations, sub-combinations, and alterations may occur depending on design requirements and other factors insofar as they are within the scope of the appended claims or the equivalents thereof.

## Claims

1. A solid-state imaging device comprising:
a semiconductor layer stacked on a first Si substrate, and including a photoelectric conversion region that has a predetermined wavelength selectivity and a floating diffusion region that converts electric charge transferred from the photoelectric conversion region into an electric signal and outputs the electric signal;
a first capacitor section formed in the first Si substrate, and holding a reset voltage of the floating diffusion region at a time when a voltage of the floating diffusion region is reset; and
a second capacitor section formed in the first Si substrate, and holding a signal voltage generated by the electric signal.

2. The solid-state imaging device according to claim 1, further comprising a readout section that reads the reset voltage from the first capacitor section and the signal voltage from the second capacitor section, wherein
the first capacitor section and the second capacitor section are branched from and coupled to a signal path from the floating diffusion region to the readout section.

3. The solid-state imaging device according to claim 1, further comprising a readout section that reads the reset voltage from the first capacitor section and the signal voltage from the second capacitor section, wherein
the second capacitor section is inserted in series into a signal path from the floating diffusion region to the readout section, and
the first capacitor section is branched from and coupled to the signal path.

4. The solid-state imaging device according to claim 1, further comprising:
a first readout section that reads the reset voltage from first capacitor section; and
a second readout section that reads the signal voltage from the second capacitor section, wherein
the first capacitor section is branched from and coupled to a first signal path from the floating diffusion region to the first readout section, and
the second capacitor section is branched from and coupled to a second signal path from the floating diffusion region to the second readout section.

5. The solid-state imaging device according to claim 2, further comprising an amplifying circuit between the floating diffusion region and the first capacitor section and between the floating diffusion region and the second capacitor section in the signal path, the amplifying circuit amplifying the electric signal.

6. The solid-state imaging device according to claim 3, further comprising an amplifying circuit between the floating diffusion region and the first capacitor section and between the floating diffusion region and the second capacitor section in the signal path, the amplifying circuit amplifying the electric signal.

7. The solid-state imaging device according to claim 4, wherein
a path between the floating diffusion region and the first capacitor section in the first signal path and a path between the floating diffusion region and the second capacitor section in the second signal path have a common path common to each other, and
the solid-state imaging device further comprises a circuit inserted into the common path, the circuit amplifying the electric signal.

8. The solid-state imaging device according to claim 1, wherein the photoelectric conversion region is formed in an InGaAs layer.

9. The solid-state imaging device according to claim 1, wherein the photoelectric conversion region is formed in an organic photoelectric conversion layer, a Ge layer, an SiGe layer, an amorphous silicon layer, or a quantum dot layer.

10. The solid-state imaging device according to claim 1, further comprising:
a first pad electrode formed on a surface of the semiconductor layer on a side of the first Si substrate, and being electrically coupled to the floating diffusion region; and
a second pad electrode formed on a surface of the first Si substrate on a side of the semiconductor layer, and being electrically coupled to the first capacitor section and the second capacitor section, wherein
the first pad electrode and the second pad electrode are coupled to each other by being attached to each other.

11. The solid-state imaging device according to claim 2, wherein the readout section is formed in the first Si substrate.

12. The solid-state imaging device according to claim 3, wherein the readout section is formed in the first Si substrate.

13. The solid-state imaging device according to claim 4, wherein the first readout section and the second readout section are formed in the first Si substrate.

14. The solid-state imaging device according to claim 2, further comprising:
a second Si substrate including the readout section, and being provided separately from the first Si substrate;
a third pad electrode formed on a surface of the first Si substrate on a side of the second Si substrate, and being electrically coupled to the first capacitor section and the second capacitor section; and
a fourth pad electrode formed on a surface of the second Si substrate on a side of the first Si substrate, and being electrically coupled to the readout section, wherein
the third pad electrode and the fourth pad electrode are bonded to each other by being attached to each other.

15. The solid-state imaging device according to claim 3, further comprising:
a second Si substrate including the readout section, and being provided separately from the first Si substrate;
a third pad electrode formed on a surface of the first Si substrate on a side of the second Si substrate, and being electrically coupled to the first capacitor section and the second capacitor section; and
a fourth pad electrode formed on a surface of the second Si substrate on a side of the first Si substrate, and being electrically coupled to the readout section, wherein
the third pad electrode and the fourth pad electrode are bonded to each other by being attached to each other.

16. The solid-state imaging device according to claim 4, further comprising:
a second Si substrate including the first readout section and the second readout section, and being provided separately from the first Si substrate;
a fifth pad electrode formed on a surface of the first Si substrate on a side of the second Si substrate, and being electrically coupled to the first capacitor section;
a sixth pad electrode formed on the surface of the first Si substrate on the side of the second Si substrate, and being electrically coupled to the second capacitor section;
a seventh pad electrode formed on a surface of the second Si substrate on a side of the first Si substrate, and being electrically coupled to the first readout section; and
an eighth pad electrode formed on the surface of the second Si substrate on the side of the first Si substrate, and being electrically coupled to the second readout section, wherein
the fifth pad electrode and the seventh pad electrode are bonded to each other by being attached to each other, and
the sixth pad electrode and the eighth pad electrode are bonded to each other by being attached to each other.

17. An electronic apparatus comprising a solid-state imaging device, wherein
the solid-state imaging device includes
a semiconductor layer stacked on a first Si substrate, and including a photoelectric conversion region that has a predetermined wavelength selectivity and a floating diffusion region that converts electric charge transferred from the photoelectric conversion region into an electric signal and outputs the electric signal,
a first capacitor section formed in the first Si substrate, and holding a reset voltage of the floating diffusion region at a time when a voltage of the floating diffusion region is reset, and
a second capacitor section formed in the first Si substrate, and holding a signal voltage generated by the electric signal.

18. A mobile body comprising a solid-state imaging device, wherein
the solid-state imaging device includes
a semiconductor layer stacked on a first Si substrate, and including a photoelectric conversion region that has a predetermined wavelength selectivity and a floating diffusion region that converts electric charge transferred from the photoelectric conversion region into an electric signal and outputs the electric signal,
a first capacitor section formed in the first Si substrate, and holding a reset voltage of the floating diffusion region at a time when a voltage of the floating diffusion region is reset, and
a second capacitor section formed in the first Si substrate, and holding a signal voltage generated by the electric signal.
